Europäisches Patentamt

European Patent Office

Office européen des brevets

(19)

(11) Publication number: **0 270 750 B1**

(12) **EUROPEAN PATENT SPECIFICATION**

(45) Date of publication of patent specification: **06.05.92**  (51) Int. Cl.[5]: **G11C 7/06**, G11C 16/06

(21) Application number: **87113241.1**

(22) Date of filing: **10.09.87**

(54) **Sense circuit for the state of matrix cells in MOS EPROM memories.**

(30) Priority: **12.12.86 IT 21682**

(43) Date of publication of application:
**15.06.88 Bulletin 88/24**

(45) Publication of the grant of the patent:
**06.05.92 Bulletin 92/19**

(84) Designated Contracting States:
**DE FR GB NL**

(56) References cited:
**US-A- 4 223 394**

**PATENT ABSTRACTS OF JAPAN, vol. 7, no.
146 (P-206)[1291], 25th June 1983; & JP-A-58
56 290**

(73) Proprietor: **SGS-THOMSON MICROELECTRON-
ICS s.r.l.
Via C. Olivetti, 2
I-20041 Agrate Brianza Milano(IT)**

(72) Inventor: **Novosel, David
R.D. No. 3 Box 332
New Wellington, PA 16142(US)**
Inventor: **Campardo, Giovanni
Via san Giacomo 22
I-24100 Bergamo(IT)**

(74) Representative: **Forattini, Amelia et al
c/o Internazionale Brevetti Ingg. ZINI,
MARANESI & C. S.r.l. Piazza Castello 1
I-20121 Milano(IT)**

Rank Xerox (UK) Business Services
(3.08/2.19/2.0)

EP 0 270 750 B1

## Description

The present invention relates to a sense circuit for the virgin or written state of matrix cells in MOS EPROM memories.

The first types of sense circuits for the (programed or virgin) state of the cells of EPROM memories employed a current source (typically a depletion transistor) as load and the cell as switch to form a simple inverter. In normal operation, if the gate of a virgin cell was brought to the supply voltage, the output of the inverter was low. If instead the cell was programed, the output of the inverter was high.

Such sense circuits according to the prior art were however affected by various disadvantages. First, the selection of the load current was critical, since it had to be small enough to allow the cell to lower the output of the inverter in the case of a virgin cell but also high enough to be able to rapidly raise the output of the inverter in the case of a programed cell, so that access time be brief. Moreover, with low supply voltages the cell conducted a very small current, and therefore the supply voltage operating interval was small, since the gate of the cell, which was brought to the supply voltage during a read operation, had to be distinctly higher than the threshold voltage, so that the conductance of the cell be greater than in the load transistor.

The operating interval was also limited by the fact that with high supply voltages even the programed cells started to conduct, causing read errors.

In order to eliminate the above described disadvantages, a differential sensing method was adopted, wherein the cells of the matrix were compared with a reference cell. In practice, the matrix cell and the reference cell derived current from two load transistors, and the voltages at the two outputs were compared by a differential amplifier. If both cells or both transistors variated in their characteristics, this caused a shift of the common-mode voltage but no variation of the differential voltage, and the dependence from the cell/load ratio was thus eliminated.

With this method, the reference cell is crossed by a current which is greater than that of the programed cell, and is equal to that of the virgin cell. If a non-zero output voltage is desired from the readout of a virgin cell, the load transistor must therefore be greater than the matrix load, usually 2 to 5 times greater.

However, this method, too, has limitations. In fact, in the linear operation region of the cells the difference between the currents in the matrix cell and in the virgin reference cell is constant, as will be described in greater detail hereinafter. As mentioned above, the state of the cell is determined by the ratio between the two currents, and since this ratio tends toward 1 as the gate voltage increases, read errors occur when this voltage exceeds a certain threshold. The operating interval is thereby limited.

The aim of the invention is therefore to provide a sense circuit for the state of matrix cells in MOS EPROM memories, having a supply voltage operating interval which is greater than that of the sense circuits according to the prior art.

The invention achieves the aim described above, as well as other objects and advantages which will become apparent hereinafter, with a sense circuit for the virgin or written state of matrix cells in MOS EPROM memories, wherein the matrix cells have their drains connected to a first preset load, and wherein an identical selection voltage is applied to the gate of a chosen matrix cell and to the gate of a virgin reference cell with a second preset load, and the respective currents which cross the two cells are compared in a differential amplifier, characterized in that the second load's conductance is double that of the first load, in that said virgin reference cell is connected in parallel to a second identical cell having its gate driven by the same selection voltage, and in that respective current generators are connected to inject in said first and said second load respective identical currents, each approximately equal to the difference between the current in the virgin cell and the current in the written cell.

A preferred embodiment of the invention will now be described, given by way of non-limitative example, with reference to the accompanying drawings, wherein:

Fig 1 is a diagram of a sense circuit according to the prior art;

Fig. 2 is an exemplary circuit diagram including the concepts of the invention; and

Fig. 3 is a diagram which is useful for understanding the operation of the invention.

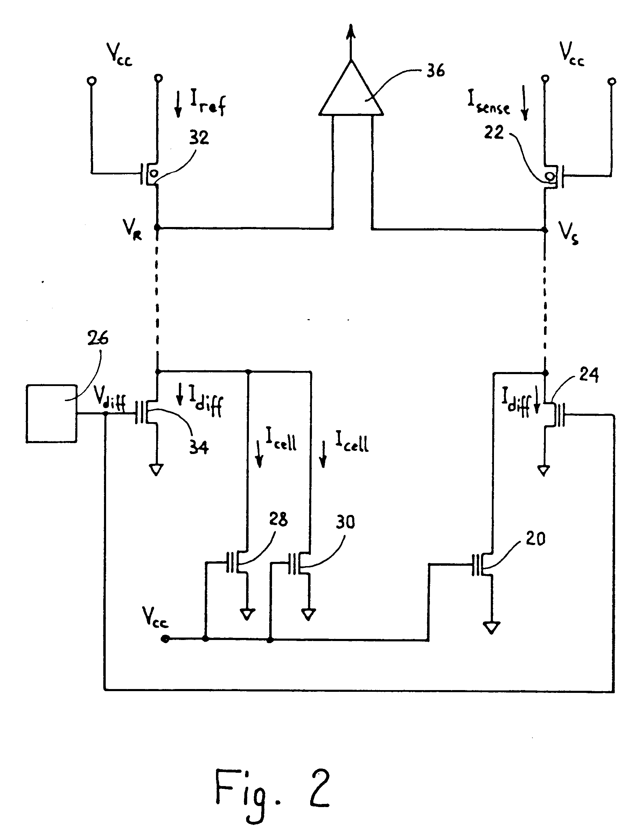

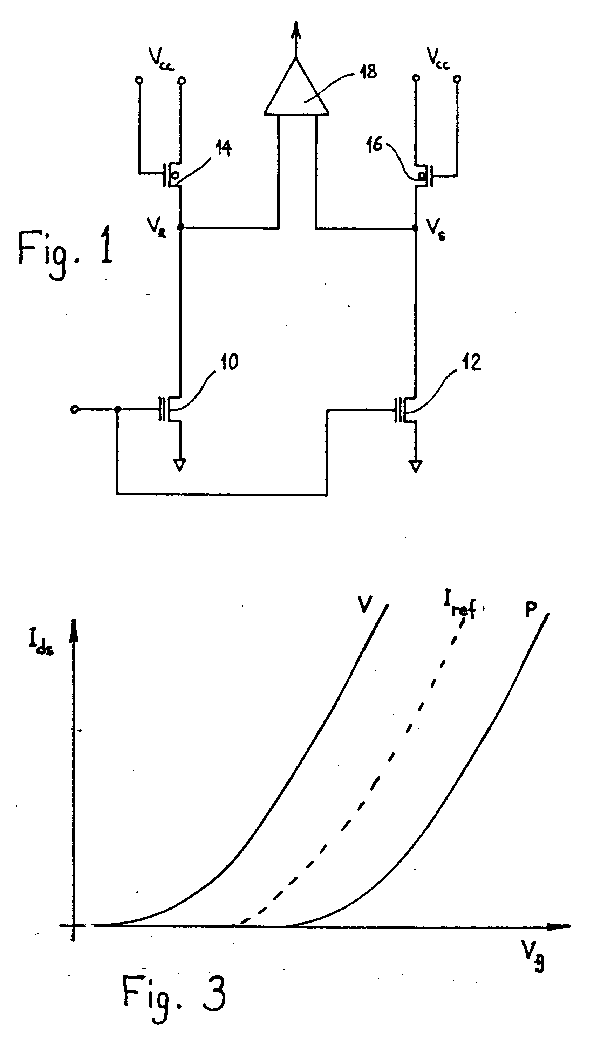

With reference to Fig. 1, the reference numerals 10 and 12 respectively indicate a virgin reference cell and a matrix cell of a MOS EPROM memory. The two cells 10 and 12 have their sources connected to the ground the gates driven in common by a control voltage $V_G$, and the drains connected to loads 14, 16, consisting of respective transistors supplied by a supply voltage $V_{CC}$ and with their gates high. The transistor 14 which constitutes the load of the reference cell is 2 to 5 times greater than the transistor 16. The drains of the cells 10 and 12 are also connected to the respective inputs of a differential amplifier 18 for sensing, adapted to provide an output which is proportional to the difference between the voltages $V_R$ and $V_S$ of the drains of the two cells.

If the supply voltage $V_{CC}$ is high enough, the cell operates in the linear region. The drain voltage is proximate to 1 volt, and the virgin threshold voltage is approximately 2.5 volt. Thus the cell will be in the linear range for gate voltages higher than 3.5 volts. The current $I_{sdV}$ in the virgin cell is:

$$I_{dsV} = K^*(V_g - V_T)^*V_{ds} - (K/2)^*V^2_{ds}$$

where $V_g$ is the gate voltage, $V_T$ is the threshold voltage, and $V_{ds}$ is the voltage drop between the drain and the source.

If the threshold shift is $\Delta V$, the current $I_{dsP}$ in the programed cell is:

$$I_{dsP} = K^*(V_g - V_T - \Delta V)^*V_{ds} - (K/2)^*V^2_{ds}$$

Since the drain voltage is constant, by setting $A = K^*V_{ds}$ and $C = (K/2)^*V^2_{ds}$, the above described equations can be reduced to

$$I_{dsV} = A^*(V_g - V_T) - C \qquad (1)$$

$$I_{dsP} = A^*(V_g - V_T - \Delta V) - C, \qquad (2)$$

which by subtraction yield the difference between the two currents:

$$I_{dsV} - I_{dsP} = A^*\Delta V. \qquad (3)$$

The difference current is thus constant for any gate voltage so long as one remains in the linear range.

Moreover, by dividing $I_{dsV}$ obtained from (3) by $I_{dsP}$, the ratio R between the two currents is obtained:

$$R = (I_{dsP} + A^*\Delta V)/I_{dsP}. \qquad (4)$$

Supposing the load transistor of the reference cell is 2 times that of the matrix cell, in order to have the sense circuit supply a logical "0" in output the ratio R must be smaller than 2. But from equation (4) it can be seen that as $I_{dsP}$ increases, that is to say, as the gate voltage $V_g$ increases, this ratio tends to 1, causing read errors if the gate voltage is too high.

The invention starts from the idea of using loads which, instead of being different for the matrix cell and for the reference cell, in order to obtain difference and non-zero voltages on the sense circuit for the two states (virgin or programed) of the matrix cell, are instead identical on the two cells, while a displacement current is injected in the comparison between the current in the matrix cell and that in the reference cell.

If the matrix cell is virgin, the difference in current between the same and the reference cell is zero. If the matrix cell is instead programed, the difference in current is a constant, that is to say $A^*\Delta V$. Thus the most desirable current value for the comparison of the matrix cell would be a current $I_S$ equal to the average between the current in the virgin cell and the current in the programed cell, that is to say

$$I_S = I_{dsP} + A^*\Delta V/2$$

In this manner, and with reference to the graph of Fig. 3, the curve of the reference current assumes the same shape as the curve of the programed current, shifted by a constant amount $\frac{1}{2}A^*\Delta V$, regardless of the value of the supply voltage. Thus the acceptable supply voltage interval for the safe discrimination between the virgin and programed states of the cell would extend in practice up to the cell's operational limits, since the curve is in every point parallel and substantially equidistant from the other two.

In theory, it is possible to obtain the current $I_S$ using a programed reference cell, rather than a virgin one, but such a cell would be erased together with the matrix cells when the memory is erased. Though it is possible to protect a cell against erasure by means of a metallic covering, this would require excessively large structures.

The invention overcomes this difficulty using a displacement current approximately equal to the difference between $I_{dsP}$ and $I_{dsV}$, which is added both to the matrix cell and the reference cell. Moreover, in the invention a second reference cell is coupled in parallel to the first, and at the same time said two reference cells are provided with two load transistors in parallel, so that the reference current is double that of the virgin cell. It will become apparent hereinafter that such a circuital combination operates in a manner substantially equivalent to that of the circuit described above.

The sense circuit according to the invention is illustrated in Fig. 2, wherein: 20 is a matrix cell; 22 is a transistor with its gate high acting as a load for the cell 20; 24 is a cell driven by a voltage generator 26 connected to inject a desired current into the load 22; 28, 30 are two identical virgin reference cells, arranged in parallel; 32 is a transistor with its gate high, and with its channel twice as wide as the transistor 22, so as to have double conductance with respect thereto; and finally 34 is another cell driven by the same voltage generator 26, and adapted to inject in 32 a current identical to that which crosses 24.

The voltage generator 26 is designed, in a manner which is obvious for the expert in the field, so as to apply to the gates of the cells 24, 34 a voltage $V_{diff}$ such as to create in each cell an identical current $I_{diff}$ approximately equal to the difference between the currents $I_{dsP}$ and $I_{dsV}$.

The voltages $V_R$ and $V_S$ produced at the ends of the loads 22, 32 by the currents which cross them are applied to the inputs of a sense differential amplifier 36, adapted to provide an output voltage which is proportional to the difference between the inputs.

Designating $I_{ref}$ as the reference current, $I_{sense}$ as the sense current in the load of the matrix cell, $I_{cell}$ as the current in the generic cell, $I_{diff}$ as the difference current between the current in the programed cell and the current in the virgin cell, the following thus occurs in the circuit branch comprising the elements 20, 22 and 24:

$$I_{sense} = I_{diff} + I_{cell} \qquad (5)$$

and in the reference branch comprising the elements 28, 30, 32 and 34:

$$I_{ref} = I_{diff} + 2^*I_{cell}; \qquad (6)$$

Since the conductance of the transistor 32 is double that of the transistor 22, the amplifier 36 compares voltages which are proportional to $I_{ref}$ and to $I_{sense}$, respectively, and from (5) and (6) the following is derived:

$$\tfrac{1}{2}I_{ref} = I_{sense} = -\tfrac{1}{2}I_{diff}.$$

Since the reference cell is always a virgin cell, the current $I_{ref}$ is equal to $I_{dsV}$, while the current $I_{sense}$ in the matrix cell is either $I_{dsV}$ or $I_{dsP}$, which are related by the relation:

$$I_{dsP} = I_{dsV} - I_{diff}. \qquad (7)$$

Thus, if the matrix cell is virgin, the difference in currents sensed by the amplifier 36 is:

$$\tfrac{1}{2}I_{ref} - I_{sense} = I_{dsV} + \tfrac{1}{2}I_{diff} - [I_{dsV} + I_{diff}]$$
$$= -\tfrac{1}{2}I_{diff}.$$

If the matrix cell is instead programed, using (7) the following is obtained:

$$\tfrac{1}{2}I_{ref} - I_{sense} = I_{dsV} + \tfrac{1}{2}I_{diff} - [I_{dsP} + I_{diff}]$$
$$= I_{dsV} + \tfrac{1}{2}I_{diff} - [I_{dsV} - I_{diff} + I_{diff}]$$
$$= \tfrac{1}{2}I_{diff}$$

It can thus be observed that the comparison between $I_{sense}$ and $I_{ref}$ provides values for the two states of the matrix cell (virgin or programed) which are substantially identical in amplitude but have opposite sign. The condition of parallelism between $I_{ref}$ and $I_{dsV}$ and $I_{dsP}$ is still true, so that the operational interval of the supply voltage is increased.

Though the Figures illustrate a single matrix cell, in the practical embodiment of the memory a plurality of cells divided in lines will be provided, and for each line there will be a sense circuit similar to the one described above

It is obvious that the exemplary diagram illustrated in Fig 3 is susceptible to variations and refinements, within the scope of the illustrated operating principles, for example in perform compensations and stabilization, as is known in the field. It is therefore understood that the scope of the invention extends to all the modifications and variations equivalent to the preferred embodiment, according to the teachings given, without thereby abandoning the scope of the invention.

**Claims**

1.  Sense circuit for the virgin or written state of matrix cells (20) in MOS EPROM memories, wherein the matrix cells have their drains connected to a first preset load (22), and wherein an identical selection voltage is applied to the gate of a chosen matrix cell (20) and to the gate of a virgin reference cell (28) with a second preset load (32), the respective currents which cross the two cells are compared in a differential amplifier, and the second load's conductance is double that of the first load, characterized in that said virgin reference cell (28) is connected in parallel to a second identical cell (30) having its gate driven by the same selection voltage, and in that respective current generators (24, 34) are connected to inject in said first and said second load respective identical currents, each approximately equal to the difference between the current in the virgin cell and the current in the written cell.

2.  Sense circuit according to claim 1 characterized in that said current generators comprise respective transistors connected in parallel respectively to said reference cell and to said matrix cell, and a fixed voltage generator (26) which drives the gates of said transistors.

3.  Sense circuit according to claim 2, characterized in that said transistors belonging to the current generators are virgin cells.

4.  Sense circuit according to one of the preceding claims, built into a solid-state EPROM memory.

## Revendications

1. Circuit de détection d'état vierge ou programmé de cellules matricielles (20) de mémoire MOS EPROM, dans lequel les drains des cellules matricielles sont reliés à une première charge (22), et dans lequel une tension identique de sélection est appliquée à la grille d'une cellule matricielle (20) choisie et à la grille d'une cellule (28) vierge de référence reliée à une deuxième charge (32), les courants respectifs qui traversent les deux cellules étant comparés dans un amplificateur différentiel, et la deuxième charge ayant une conductance double de celle de la première charge, caractérisé en ce que ladite cellule (28) vierge de référence est reliée en parallèle à une deuxième cellule (30) identique à grille commandée par la même tension de sélection, et en ce que des générateurs de courant respectifs (24, 34) sont reliés pour injecter dans lesdites première et deuxième charges des courants respectifs identiques, chacun étant approximativement égal à la différence entre le courant dans la cellule vierge et le courant dans la cellule programmée.

2. Circuit selon la revendication 1, caractérisé en ce que lesdits générateurs de courant comprennent des transistors respectifs reliés en parallèle respectivement à ladite cellule de référence et à ladite cellule matricielle, et un générateur de tension fixe (26) qui commande les grilles desdits transistors.

3. Circuit selon la revendication 2, caractérisé en ce que lesdits transistors appartenant au générateur de courant sont des cellules vierges.

4. Circuit selon l'une quelconque des revendications précédentes, caractérisé en ce qu'il est intégré dans une mémoire EPROM.

## Patentansprüche

1. Fühlerschaltung für den unbenutzten oder beschriebenen Zustand von Matrixzellen (20) in einem MOS-EPROM-Speicher, wobei die Drainanschlüsse der Matrixzellen mit einer ersten voreingestellten Last (22) verbunden sind, und wobei eine identische Auswahlspannung an den Gateanschluß einer ausgewählten Matrixzelle (20) und an den Gateanschluß einer unbenutzten Referenzzelle (28) mit einer zweiten voreingestellten Last (32) gelegt wird, die jeweiligen Ströme, welche durch die zwei Zellen treten, in einem Differentialverstärker verglichen werden, und die Konduktanz der zweiten Last doppelt so groß wie diejenige der ersten Last ist, **dadurch gekennzeichnet,** daß die unbenutzte Referenzzelle (28) parallel an eine zweite identische Zelle (30), deren Gateanschluß durch die gleiche Auswahlspannung gespeist wird, angeschlossen ist, und daß jeweilige Stromgeneratoren (24, 34) angeschlossen sind, um in die erste und zweite Last jeweilige identische Ströme einzuspeisen, wobei jeder ungefähr gleich der Differenz zwischen dem Strom in der unbenutzten Zelle und dem Strom in der beschriebenen Zelle ist.

2. Fühlerschaltung nach Anspruch 1, **dadurch gekennzeichnet,** daß die Stromgeneratoren jeweilige Transistoren, die parallel zu der jeweiligen Referenzzelle und zu der Matrixzelle geschaltet sind, und einen Konstantspannungsgenerator (26), welcher die Gateanschlüsse der Transistoren speist, umfassen.

3. Fühlerschaltung nach Anspruch 2, **dadurch gekennzeichnet,** daß die zu den Stromgeneratoren gehörenden Transistoren unbenutzte Zellen sind.

4. Fühlerschaltung nach wenigstens einem der vorhergehenden Ansprüche, eingebaut in einen Festkörper-EPROM-Speicher.

Fig. 2

Fig. 1

Fig. 3